# EUROPEAN PATENT APPLICATION

(11) **EP 4 407 323 A1**
(43) Date of publication of application: **31.07.2024**
(21) Application number: 24152052.7
(22) Date of filing: 16.01.2024
(51) Int. Cl.: G01R 1/04

(54) **SOCKET FOR TESTING OF AN INTEGRATED CIRCUIT**

(30) Priority: 27.01.2023 IT 202300001323
(71) Applicant: Officina Meccanica Di Precisione G.3, 20092 Cinisello Balsamo (Milano) (IT)
(72) Inventor: COPETA, Alessandro, Borgosatollo (Brescia) (IT); FRIGERIO, Gianluigi, Usmate Velate (Monza Brianza) (IT)
(74) Representative: Rapisardi, Mariacristina

(57) **Abstract**

A socket (1) for testing an integrated circuit (20), comprising a body (10) having a sliding cavity (11) having an insertion station (12) for the integrated circuit (20) and a test station (13) for the integrated circuit (20) delimited by a flat lower wall (14) having a plurality of through holes (41) at the test station (13) and a flat upper wall (15) parallel to the flat lower wall (14), a movable member (30) for transferring the integrated circuit (20) from the insertion station (12) and for retaining it in the test station (13), a movable electrical contact pad (40) positioned below the flat lower wall (14) at the test station (13) and having a plurality of spring pins (42) which are coincident and movable through the plurality of through holes (41) to electrically contact said integrated circuit (20) and lift it from a position of rest on said flat lower wall (14) to a blocked position contrasting against the flat upper wall (15), first movement means (100) for moving the movable electrical contact pad (40) and second movement means (200) for moving the transfer and retaining member (30), the first movement means (100) and the second movement means (200) being mechanical means for linear mechanical movement.

## Description

The present invention relates to a test stand for testing an integrated circuit.

Manufacturers of integrated circuits use very complex equipment to test and prove their circuits. A delicate part of such equipment are the locations on which circuits are temporarily fixed during testing.

These locations, generally referred to as 'sockets' in Anglo-American terminology, must have the following characteristics: allow precise positioning of the integrated circuit under test; lock this circuit in the test position (and then easily unlock it when the test is complete); establish an electrical connection between the terminals of the integrated circuit and those of the test machine; ensure that during the test, the integrated circuit is not subjected to undue pressure, in the sense that too forceful a grasp could affect its behaviour, compromising the validity of the test; and have a very long active life, i.e. allow a very high number of test cycles.

Each test cycle consists of the following phases: insertion of the IC; fixing of the IC and (usually simultaneously) establishment of the electrical contacts with the terminals inserted in the socket; testing, generally performed automatically by a computer interfaced with the electrical connections of the socket; removal of the mechanical constraints that fixed the IC in the test position; removal of the IC; and a waiting phase before inserting a new IC.

Until recently, tests on IC took place under static conditions (IC held stationary under test).

The latest industry requirements call for testing under dynamic conditions, i.e. the IC must be subjected to inertial stimuli with possible addition of thermal stimuli, and tested electrically.

The need arises from the need to ensure the proper functioning of electronic equipment installed in environments affected by vibrations, such as on-board vehicle equipment.

In order to allow this type of test, the sockets must have two further characteristics: they must allow such a strong and stable grip that they do not loosen during vibrations (which will obviously affect the sockets themselves as well as the integrated component), while maintaining the caution of not mechanically overstressing the integrated circuit itself; and they must be sufficiently manageable and strong enough overall to allow it to vibrate without structural deterioration and maintaining a multipolar electrical connection with the test machine.

The operating principle is realised in two basic versions, one with mechanical drive and the other with pneumatic drive.

In summary, the operating principle is as follows.

Initially, the IC is supported by a manipulator through a transport and gripping device, usually a kind of suction cup.

The manipulator moves in such a way as to insert the circuit into the pocket in the socket.

The contacts for circuit verification of the integrated circuit are provided there.

When the integrated circuit is in position, one or more retaining organs that block the integrated circuit come into action in the pocket, while the transport and gripping organ of the manipulator, after releasing the integrated circuit locked in the pocket, moves away.

This is followed by the test phase, then in the reverse procedure the manipulator returns to grasp the integrated circuit, the retaining organs are withdrawn, and the integrated circuit is removed from the pocket.

The following features are characteristic in all of this: the transport and gripping organs have a footprint compatible with the dimensions of the pocket; between the instant when the manipulator releases the integrated circuit and the instant when it is blocked by the retaining organs, means must be provided to prevent the integrated circuit from leaving the pocket; the motion of the transport and gripping organs is independent of the socket, controlled by a special manipulator capable of moving along the planned trajectory with the precision required to insert the integrated circuit into the test pocket; the motion of the retaining parts, mounted on board the socket, is enslaved to the motion of the manipulator so as to allow the necessary synchronisms; the socket pocket is equipped with sloping edges to facilitate the insertion and centring of the integrated circuit; the socket pocket is equipped with contacts and the relative circuitry and protection organs to allow the circuit interface of the integrated circuit with the computer that is to perform the test. As mentioned above, the actuation of the retaining organs is subject to the law of motion of the manipulator's transport and gripping organ.

In commercially available versions, this drive can use mechanical or pneumatic technology.

In the production of integrated circuits, there is a strong trend towards miniaturisation, which also makes the integrated circuit more sensitive to contact pressure.

In some of the more recent known solutions, the socket accommodates a horizontally movable transport organ to align the integrated circuit to an electrical contact pad, which in turn can be moved vertically upwards to connect electrically to the integrated circuit and lock it in test position against an overhanging feedback wall.

Traditionally, pneumatic actuators internal to the socket are used for the movement of the electrical contact pad and the pusher, which require the provision of air chambers and their seals that may be subject to thermal fatigue in the event of tests taking place in very wide temperature ranges.

The technical task proposed by the present invention is to realise a socket for testing of a miniaturised workpiece that eliminates the complained of drawbacks of the known technique.

In the context of this technical task, one aim of the invention is to provide a suitably structured socket to withstand tests with inertial stimuli and thermal cycling over time so as to provide an accurate, precise and repeatable result.

This and other purposes are achieved according to the invention by a socket for testing an integrated circuit, comprising a body having a sliding cavity having an insertion station for said integrated circuit and a test station for said integrated circuit delimited by a flat lower wall having a plurality of through holes at said test station and a flat upper wall parallel to said flat lower wall, a movable member for transferring said integrated circuit from said insertion station and for retaining it in said test station, a movable electrical contact pad positioned below said flat lower wall at said test station and having a plurality of spring pins which are coincident and movable through said plurality of through holes to electrically contact said integrated circuit and lift it from a position of rest on said flat lower wall to a blocked position contrasting against said flat upper wall, first movement means for moving said movable electrical contact pad and second movement means for moving said transfer and retaining member, characterized in that said first movement means and said second movement means are mechanical means for linear mechanical movement. In one embodiment, the first movement means is configured and arranged for the linear mechanical movement of said movable electrical contact pad orthogonally to said flat lower wall at said test station.

In one embodiment, the second movement means is configured and arranged for the linear mechanical movement of said transfer and retaining member in said sliding cavity parallel to said flat lower wall.

Further features and advantages of the invention will become more apparent from the description of preferred but not exclusive forms of execution of the socket for testing an integrated circuit according to the invention, illustrated by way of illustration and not limitation in the accompanying drawings, in which
Figure 1 shows the assembly of a modular test apparatus with a plurality of socket modules conforming to a first embodiment;
Figures 2 A, 2 B, 2 C, 2 D show a schematic cross-section of the side elevation of the socket module in accordance with the first embodiment, with the circuit integrated in the threading, insertion, translation and test stations respectively;
Figure 3 shows an AA detail of Figure 2 D;
Figures 4 A, 4 B show a schematic plan view from above of a socket according to the first embodiment of the invention, with the integrated circuit in the insertion station and test station respectively;
Figures 5 A, 5 B show a schematic plan view from the top of the socket according to a second embodiment of the invention, with the integrated circuit in the insertion station and test station respectively;
Figures 6 A, 6 B show a schematic plan view from the top of the socket according to a third embodiment of the invention, with the integrated circuit in the insertion station and test station respectively;
Figure 7 shows a schematic view in side elevation of the first means of linear mechanical movement of the electrical contact pad;
Figure 8 shows a schematic plan view of the second means of linear mechanical movement of the transfer and retaining member.

The following detailed description refers to the attached drawings, which form part of it.

In drawings, similar reference numbers typically identify similar components, unless the context indicates otherwise.

The illustrative forms of realisation described in the detailed description and drawings are not intended in a limiting sense.

Other forms of realisation may be used, and other modifications may be made without departing from the spirit or scope of the subject matter depicted here.

The aspects of this description, as generally described in this context and illustrated in the figures, can be arranged, substituted, combined, and designed in a wide variety of different configurations, all of which are explicitly contemplated and are part of this description.

With reference to the above-mentioned figures, a socket 1 for testing an integrated circuit is illustrated.

Socket 1 for testing an integrated circuit 20 comprises a body 10 having a sliding cavity 11, typically horizontal in development, which has an insertion station 12 of the integrated circuit 20 and a test station 13 of the integrated circuit 20.

The sliding cavity 11 is delimited by a flat lower wall 14, which has a plurality of through-holes 41 at the test station 13, and a flat upper wall 15, parallel to the flat lower wall 14.

In the sliding cavity 11, there is a movable member 30 for reversible transfer of the integrated circuit 20 from the insertion station 12 to the test station 13, wherein the movable member 30 favourably retains the integrated circuit 20.

The movable transfer and retaining member 30 typically has a head 31 and a hook terminal 32 which extends anteriorly to the head 31, and delimits with the head 31 a housing compartment 33 of the integrated circuit 20.

Suitably, the head 31 is configured and arranged to push the IC 20 forward from the insertion station 12 to the test station 13; the hook terminal 32 is configured and arranged to push the IC 20 backward from the test station 13 to the insertion station 12, coinciding with the station for extracting the IC 20 from the body 10.

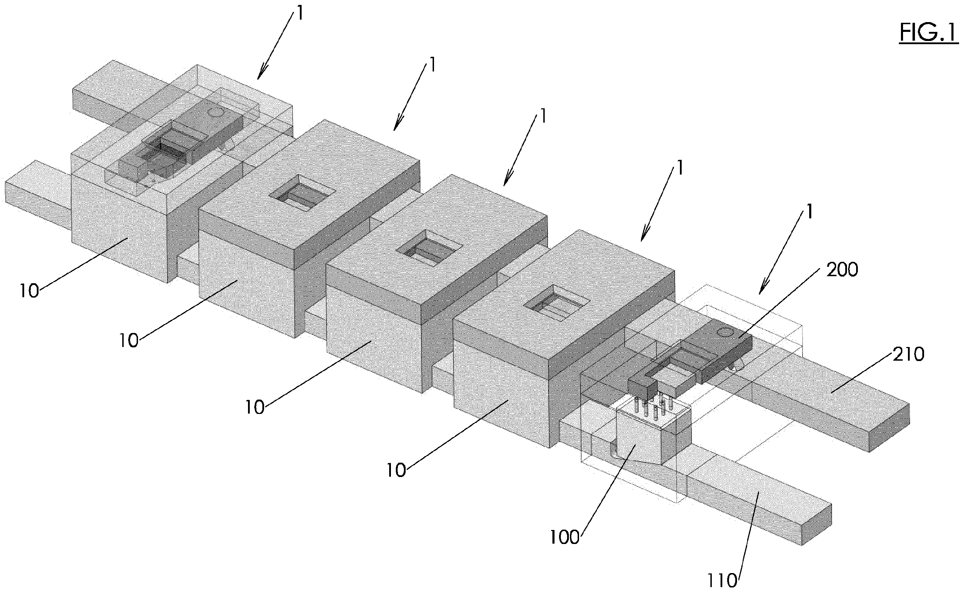

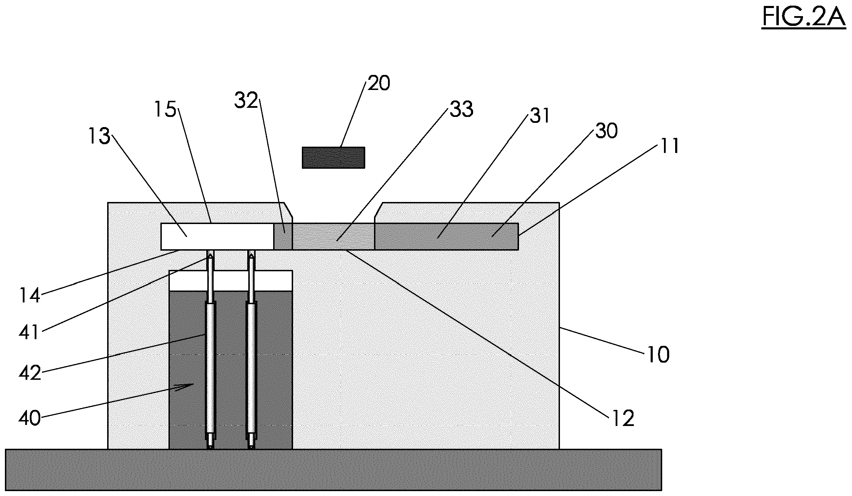

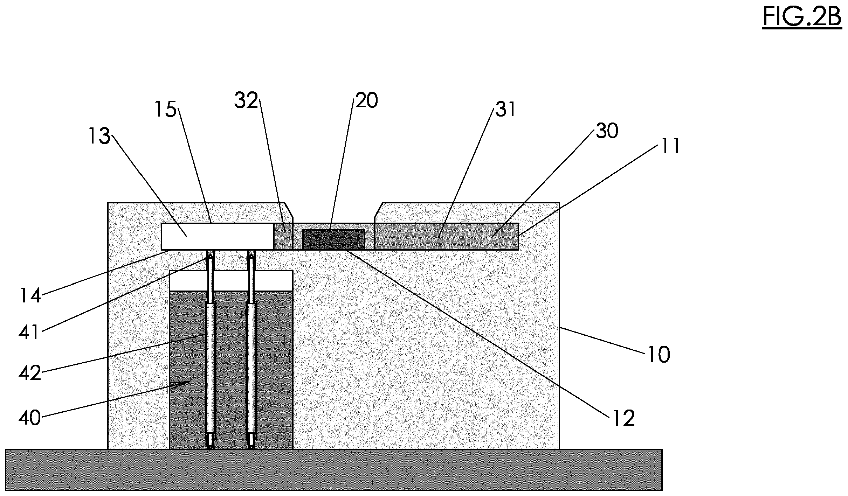

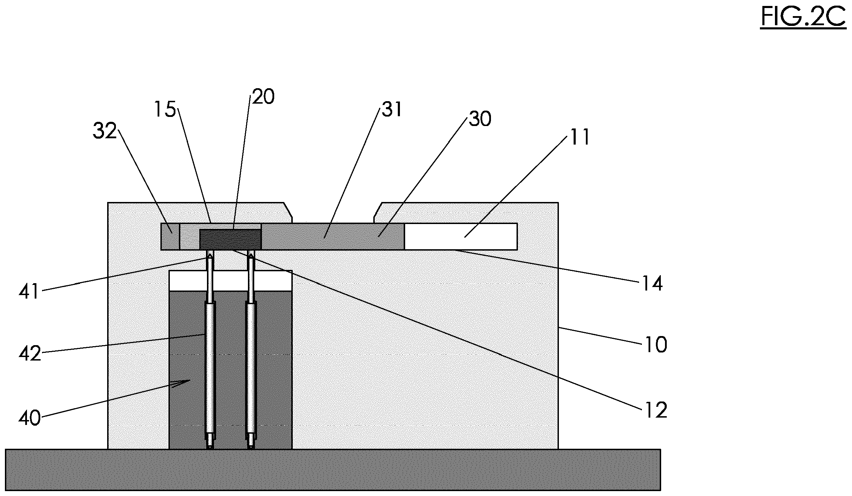

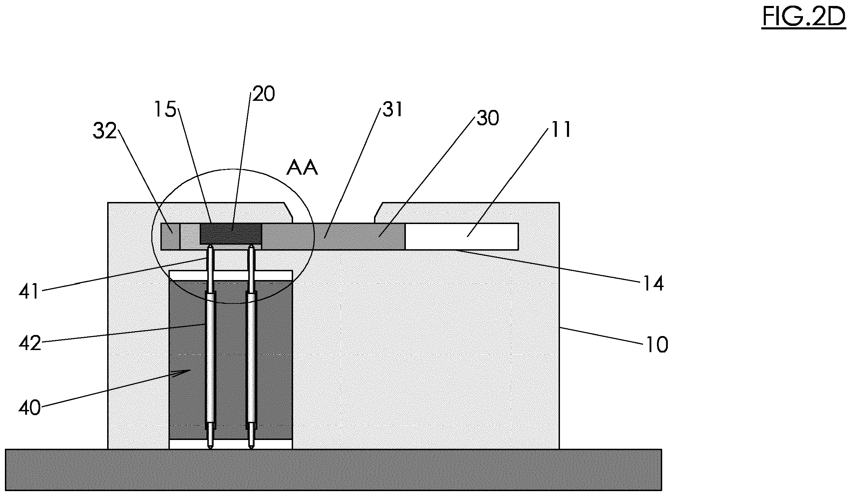

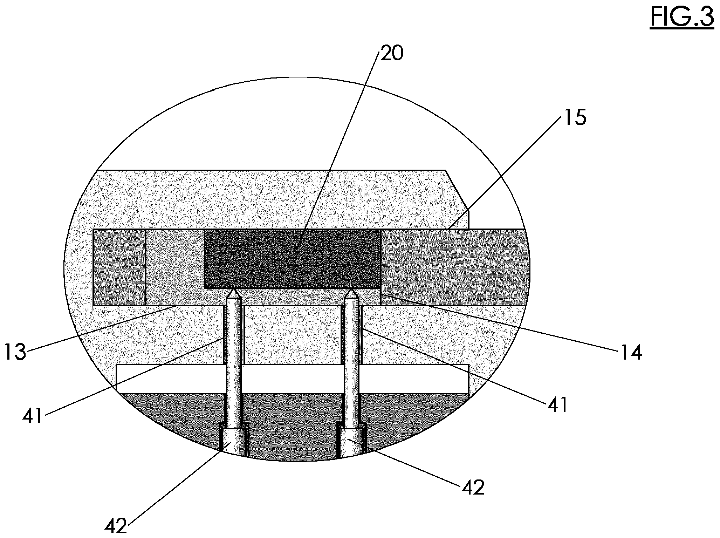

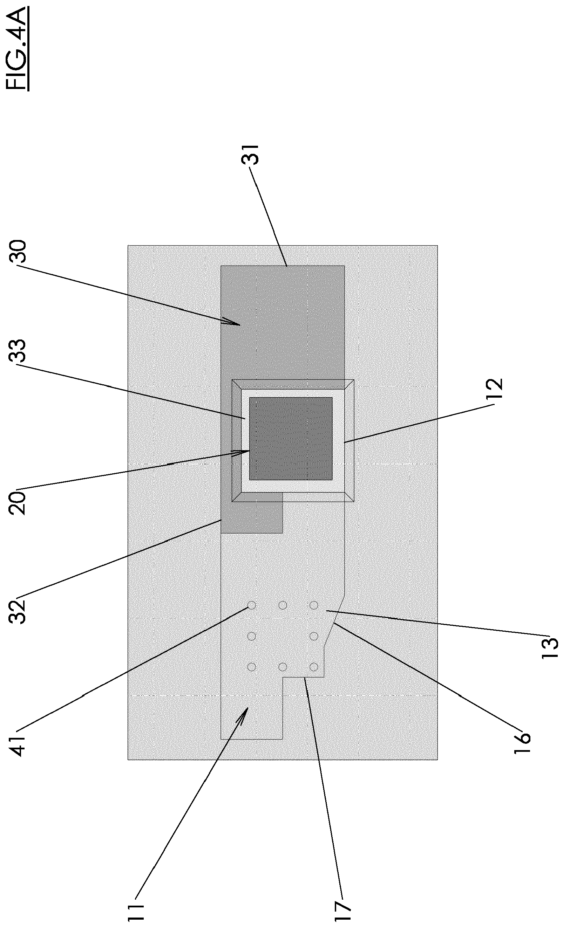

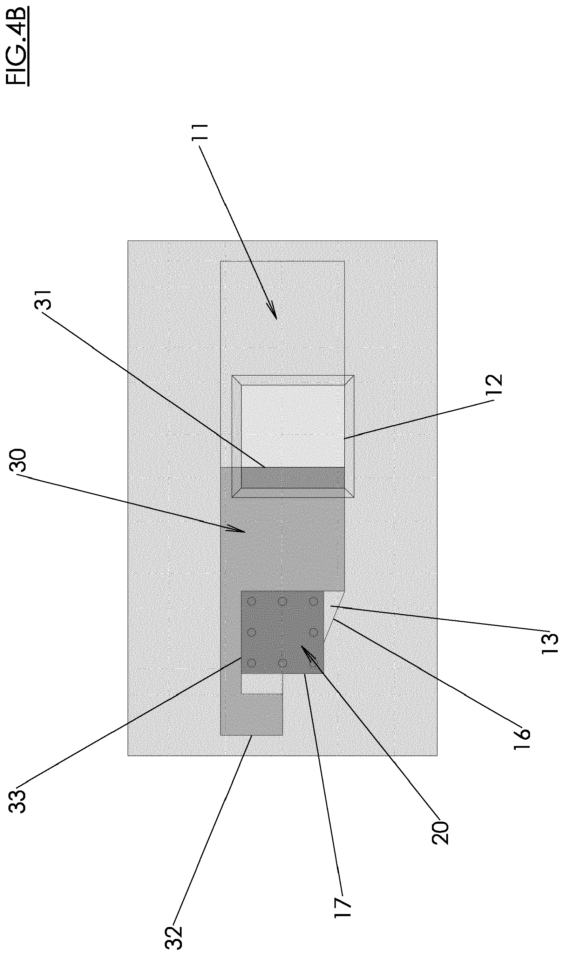

In a first preferred but not exclusive embodiment, schematically depicted in Figures 1 to 4 A, B, the head 31 and hook terminal 32 are in one piece, and rigidly connected.

The sliding cavity 11 has a side wall 16 oblique with respect to a linear movement direction of the transfer member 30 configured and arranged for guiding the integrated circuit 20 in the test station 13, and is longitudinally delimited by a rebate wall 17, against which, in the present embodiment, the sliding of the integrated circuit 20 is stopped by the front face of the head 31 of the moving member 30.

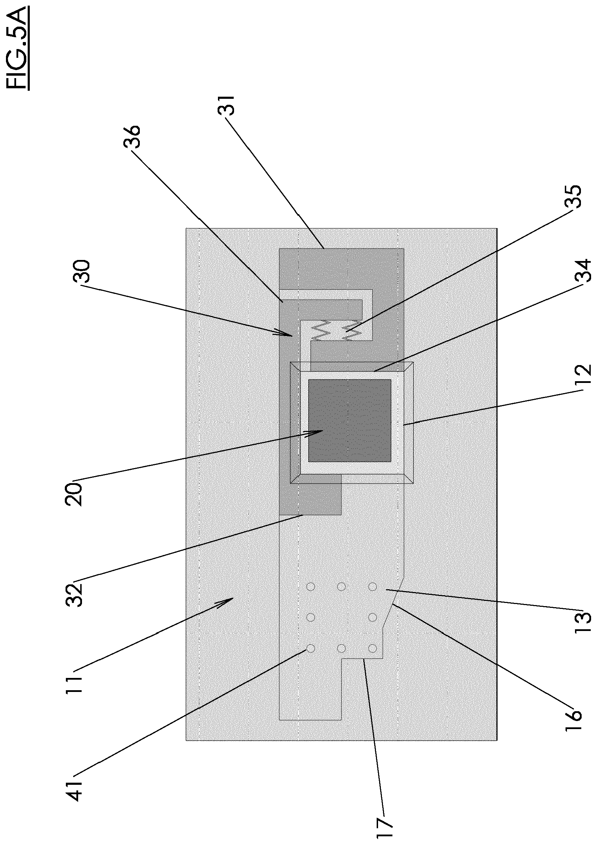

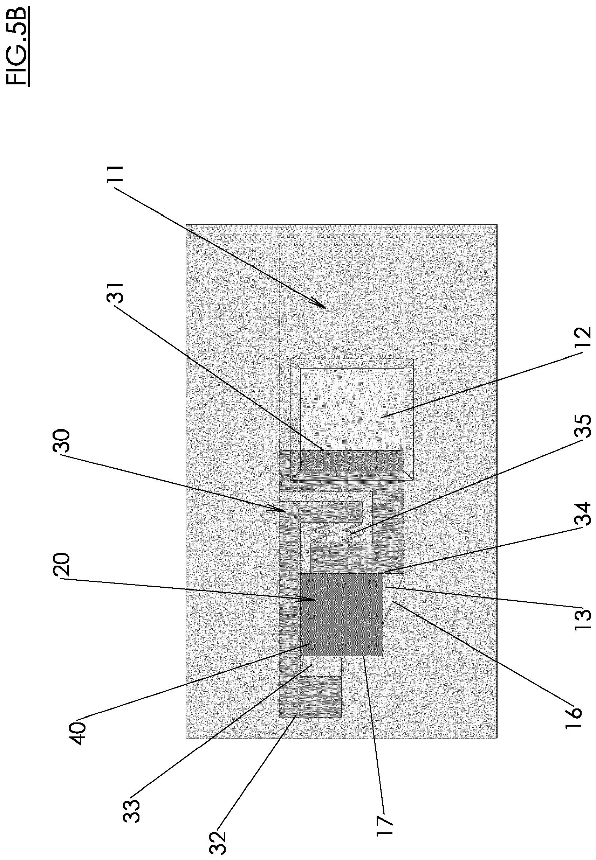

In a second preferred but not exclusive embodiment, schematically depicted in Figures 5 A, 5 B, the head 31 and the hook terminal 32 are configured in at least two pieces connected by means of an elestic element 35, formed as an example by two coil springs operating in parallel.

The head 31 has a front shank 34, the hook terminal 32 has a rear shank 36 which extends to the rear of the front shank 34 of the head 31: the elastic element 35 connects the front shank 34 of the head 31 with the rear shank 36 of the hook terminal 32.

Consistent with the first embodiment shown above, the sliding cavity 11 has a side wall 16 oblique with respect to a linear movement direction of the transfer member 30 configured and arranged for guiding the integrated circuit 20 in the test station 13 , and is longitudinally delimited by a rebate wall 17, against which, in the present embodiment, the sliding of the integrated circuit 20 held in a contrasting position by the front shank 34 of the moving member 30 stops.

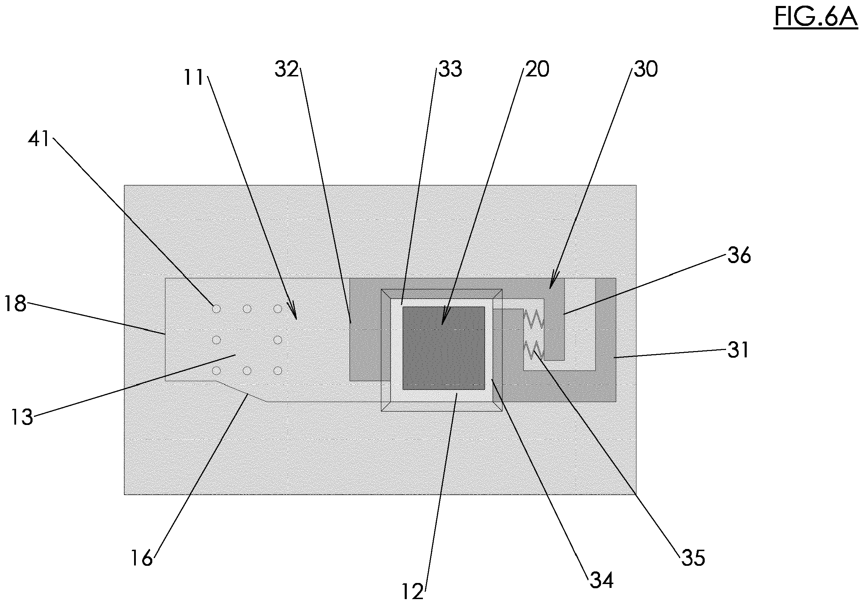

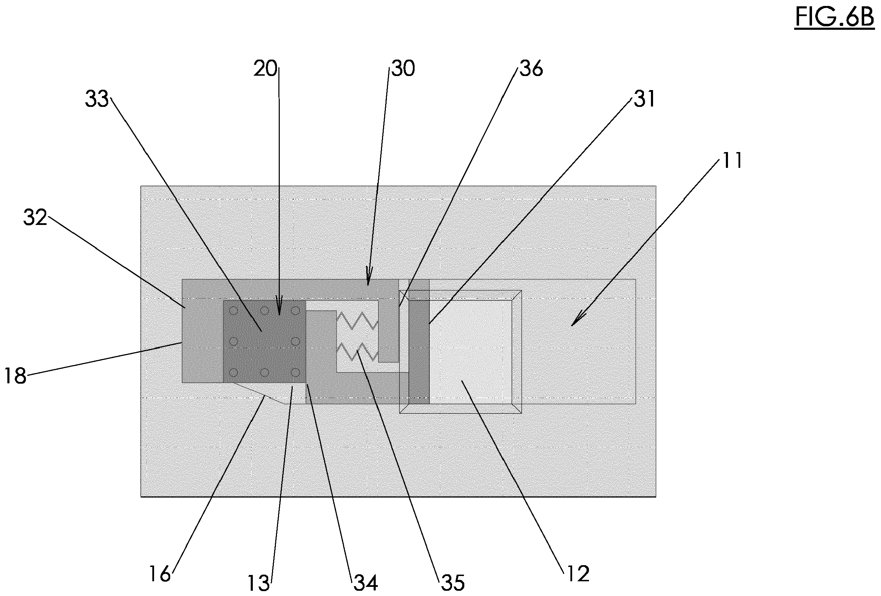

A third preferred but non-exclusive embodiment is schematically depicted in Figures 6 A and 6 B: this third embodiment differs from the second embodiment described above wherein the rebate wall 17 is not present, and the integrated circuit 20 is held in place on the test station 13 in contrast to the front shank 34 of the head 31 and the hook terminal 32 of the movable member 30 in rebate on the end wall 18 of the sliding cavity 11.

For the electrical test and inspection of the integrated circuit 20, a movable electrical contact pad 40 is conveniently placed under the lower 14 flat wall of the test station 13.

The movable electrical contact pad 40 has a plurality of spring-loaded pins 42 coinciding and movable through the plurality of through-holes 41 , suitably positioned at the test station 13 to electrically contact the integrated circuit 20.

The vertical movement of the movable electrical contact pad 40 pushes the spring-loaded pins 42 through the through-holes 41 and in contrast to the integrated circuit 20 above, which is lifted from a resting position on the flat lower wall 14 to a blocking position and contrasted against the flat upper wall 15.

Appropriately and innovatively, according to the present invention, movement in the vertical plane of the movable electrical pad 40 through the plurality of through-holes 41, and movement in the horizontal plane of the movable member 30 in the sliding cavity 11 is due to movement means, respectively, first movement means 100 and second movement means 200, wherein said first movement means 100 and second movement means 200 are linear mechanical movement means. Typically, a first mechanical linear actuator 110 activates the first means 100 of linear mechanical movement that moves the movable electrical pad 40 vertically and orthogonally to the lower 14 flat wall of the test station 13.

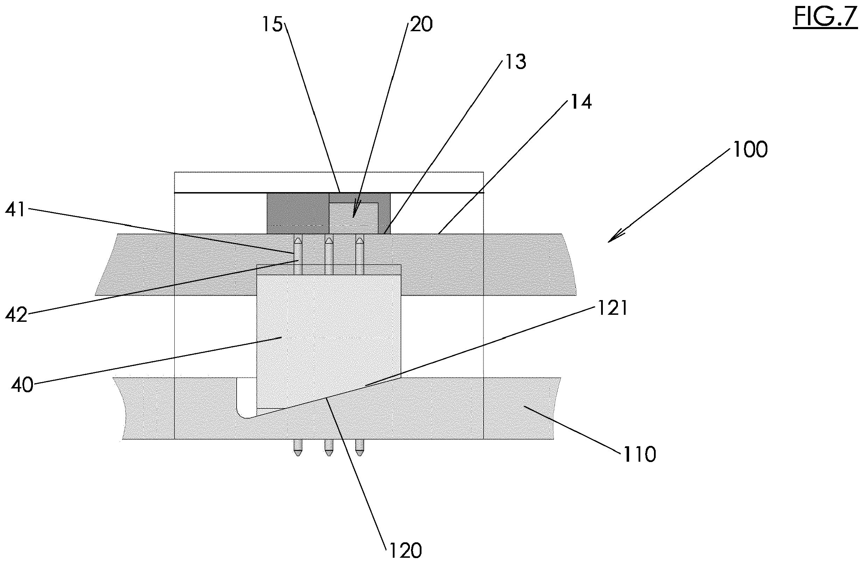

In a preferred but non-exclusive embodiment of the present invention, schematically illustrated in Figure 7, the first means 100 of mechanical linear movement comprises two inclined planes 120 and 121 that are parallel, associated and matching.

The inclined plane 120 is integral with the first mechanical linear actuator 110, the inclined plane 121 is integral with the movable electrical contact pad 40.

The actuation in horizontal movement f the first mechanical linear actuator 110 causes the two parallel associated and matching inclined planes 120 and 121 to slide reciprocally, vertically moving the movable electrical contact pad 40 and the movable spring pins 42 through the through-holes 41 in contrast and opposition to the integrated circuit 20 in the test position 13. Advantageously, according to the present invention, electrical test contact is achieved by lifting vertically with the movable spring pins 42 and pressing the integrated circuit 20 against the flat upper wall 15: advantageously and appropriately, the first means 100 of linear mechanical movement can be completely concealed under the test station 13 and actuated with on-axis loads, without any deflection, with a centred force and with greater modulation possibilities.

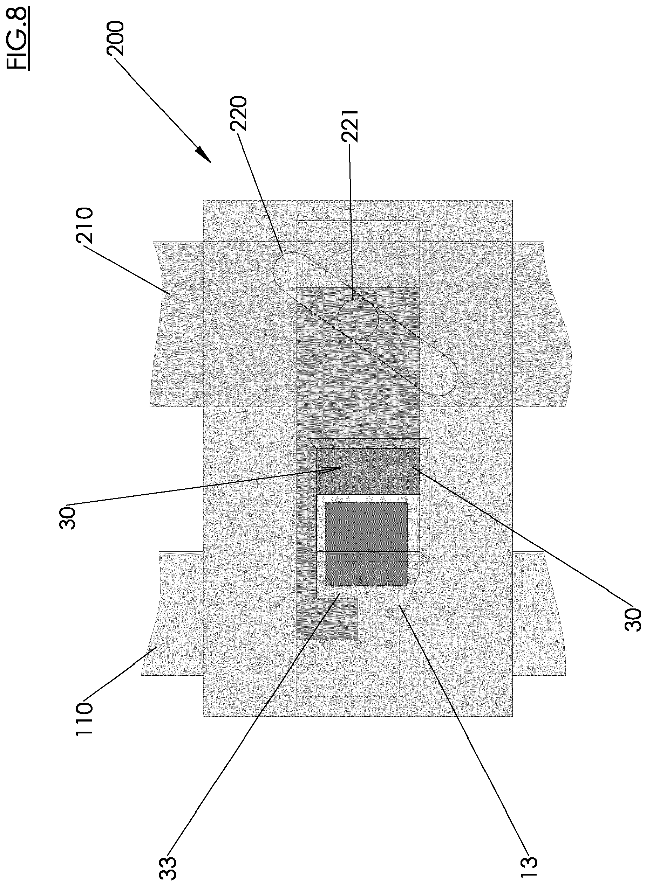

Typically, a second mechanical linear actuator 210 activates the second means 200 of mechanical linear movement that horizontally move the movable transfer and retaining member 30 in the sliding cavity 11 parallel to the flat lower wall 14 of the insertion station 12 and test station 13. In a preferred but not exclusive embodiment of the present invention, schematically shown in Figure 8, the second means 200 of linear mechanical movement comprise an inclined slot 220 and a pin 221.

The inclined slot 220 is integral with the second mechanical linear actuator 210, the pin 221 is engaged in the inclined slot 220 and is integral with the movable reversible transfer member 30 of the integrated circuit 20.

The horizontally moving actuation of the second mechanical linear actuator 210 causes the reciprocal sliding of the pin 221 in the inclined slot 220, horizontally moving the reversible transfer member 30 in the sliding cavity 11 from the insertion station 12 to the test station 13 of the integrated circuit 20.

The operation of the socket for testing an integrated circuit according to the invention is apparent from what is described and illustrated; the activation and movement of the movement means (not shown in the figures) for inserting and retrieving the integrated circuit into/from the insertion pocket of the socket, the activation and movement of the first and second linear mechanical movement means, the electrical activation of the movable electrical contact pad, the activation of the mechanical and physical test conditions of the integrated circuit, the retrieval of the test data are coordinated and activated by a control and supervision system of a known type.

In practice, it has been found that a socket for testing an integrated circuit according to the invention is particularly advantageous due to the fact that the movable transfer and retaining member and the electrical contact pad, both animated by a simple linear mechanical movement, absolutely guarantee parallelism with respect to the main flat faces of the integrated circuit, and thus ensure uniformity in the application of the mechanical and electrical test load.

A further advantage of the present invention is that the integrated circuit can be positioned with great precision in the test station.

A further advantage of the present invention is that the pressure force is transmitted to the integrated circuit by means of a linear actuator with an on-axis load, as it is a non-reversing system, and this force can always be calibrated with the required precision even for a particularly thin, pressure-sensitive integrated circuit.

A further advantage of the present invention is thus to be able to control with particular care both the magnitude of the force with which the integrated circuits are pressed against the electrical contact pad and the uniformity with which this force is distributed over the entire surface of the integrated circuits.

The socket thus conceived is susceptible to numerous modifications and variations, all within the scope of the inventive concept; moreover, all details are replaceable by technically equivalent elements.

In practice, the materials used, as well as the dimensions, can be any according to requirements and the state of the art.

## Claims

1. A socket (1) for testing an integrated circuit (20), comprising a body (10) having a sliding cavity (11) having an insertion station (12) for said integrated circuit (20) and a test station (13) for said integrated circuit (20) delimited by a flat lower wall (14) having a plurality of through holes (41) at said test station (13) and a flat upper wall (15) parallel to said flat lower wall (14), a movable member (30) for transferring said integrated circuit (20) from said insertion station (12) and for retaining it in said test station (13), a movable electrical contact pad (40) positioned below said flat lower wall (14) at said test station (13) and having a plurality of spring pins (42) which are coincident and movable through said plurality of through holes (41) to electrically contact said integrated circuit (20) and lift it from a position of rest on said flat lower wall (14) to a blocked position contrasting against said flat upper wall (15), first movement means (100) for moving said movable electrical contact pad (40) and second movement means (200) for moving said transfer and retaining member (30), **characterized in that** said first movement means (100) and said second movement means (200) are mechanical means for linear mechanical movement.

2. The socket (1) for testing an integrated circuit (20) according to claim 1, **characterized in that** said first movement means (100) is configured and arranged for the linear mechanical movement of said movable electrical contact pad (40) orthogonally to said flat lower wall (14) at said test station (13).

3. The socket (1) for testing an integrated circuit (20) according to any preceding claim, **characterized in that** said second movement means (200) is configured and arranged for the linear mechanical movement of said transfer and retaining member (30) in said sliding cavity (11) parallel to said flat lower wall (14).

4. The socket (1) for testing an integrated circuit (20) according to any preceding claim, **characterized in that** said first movement means (100) and said second movement means (200) are activated by linear mechanical activation means, respectively first linear mechanical actuator (110) and second linear mechanical actuator (210).

5. The socket (1) for testing an integrated circuit (20) according to any preceding claim, **characterized in that** said first movement means (100) comprises two associated and matching parallel inclined surfaces (120, 121).

6. The socket (1) for testing an integrated circuit (20) according to the preceding claim, **characterized in that** said inclined surface (120) is solidly constrained to said first linear mechanical actuator (110), and said inclined surface (121) is solidly constrained to said movable electrical contact pad (40).

7. The socket (1) for testing an integrated circuit (20) according to any preceding claim, **characterized in that** said second movement means (200) comprises an inclined slot (220) and a pin (221).

8. The socket (1) for testing an integrated circuit (20) according to the preceding claim, **characterized in that** said inclined slot (220) is solidly constrained to said second linear mechanical actuator (210), said pin (221) being engaged in said inclined slot (220) and being solidly constrained to said movable member (30) for the reversible transfer of said integrated circuit (20).

9. The socket (1) for testing an integrated circuit (20) according to any preceding claim, **characterized in that** said movable transfer and retaining member (30) has a head (31) and a hook terminal (32) extending forward of said head (31) and delimiting with said head (31) a housing compartment (33) for said integrated circuit (20), said head (31) being configured and arranged to push said integrated circuit (20) forward from said insertion station (12) to said test station (13) and said hook terminal (32) being configured and arranged to bring said integrated circuit (20) back from said test station (13) to said insertion station (12).

10. The socket (1) for testing an integrated circuit (20) according to the preceding claim, **characterized in that** said head (31) and said hook terminal (32) are rigidly connected.

11. The socket (1) for testing an integrated circuit (20) according to claim 9, **characterized in that** said head (31) and said hook terminal (32) are connected via an elastic element (35).

12. The socket (1) for testing an integrated circuit (20) according to the preceding claim, **characterized in that** said head (31) has a front shank (34), said hook terminal (32) has a rear shank (36) that extends rearwardly to said front shank (34) of said head (31), said elastic element (35) connecting said front shank (34) of said head (31) with said rear shank (36) of said hook terminal (32).

13. The socket (1) for testing an integrated circuit (20) according to any preceding claim, **characterized in that** said sliding cavity (11) has a side wall (16) which is oblique relative to a linear movement direction of said transfer member (30) and which is configured and arranged for guiding said integrated circuit (20) in said test station (13).
